# EUROPÄISCHE PATENTSCHRIFT

(11) **EP 3 806 261 B1**
(45) Veröffentlichungstag und Bekanntmachung des Hinweises auf die Patenterteilung: **13.07.2022**
(21) Anmeldenummer: 20198301.2
(22) Anmeldetag: 25.09.2020
(51) Int. Cl.: H02J 3/00, H02J 3/38

(54) **VERFAHREN ZUM SPANNUNGSPRÄGENDEN EINSPEISEN ELEKTRISCHER LEISTUNG IN EIN ELEKTRISCHES VERSORGUNGSNETZ MITTELS EINER WINDENERGIEANLAGE**
METHOD FOR FEEDING ELECTRICAL POWER INTO AN ELECTRICAL SUPPLY NETWORK BY MEANS OF A WIND ENERGY PLANT IN A MANNER WHICH CONTROLS VOLTAGE
PROCÉDÉ D'ALIMENTATION CARACTÉRISÉE PAR TENSION D'ÉNERGIE ÉLECTRIQUE DANS UN RÉSEAU D'ALIMENTATION ÉLECTRIQUE AU MOYEN D'UNE ÉOLIENNE

(30) Priorität: 11.10.2019 DE 102019127484
(43) Veröffentlichungstag der Anmeldung: 14.04.2021
(73) Patentinhaber: Wobben Properties GmbH, 26607 Aurich (DE)
(72) Erfinder: Brombach, Johannes, 13437 Berlin (DE); Quitmann, Eckard, 28199 Bremen (DE); Emanuel, Hanna, 28203 Bremen (DE)
(74) Vertreter: Eisenführ Speiser

(56) Entgegenhaltungen:
- WO-A1-2019/120397

## Beschreibung

Die vorliegende Erfindung betrifft ein Verfahren zum Einspeisen elektrischer Leistung in ein elektrisches Versorgungsnetz mittels einer Windenergieanlage. Außerdem betrifft die vorliegende Erfindung eine entsprechende Windenergieanlage.

Windenergieanlagen sind bekannt. Sie speisen elektrische Leistung in ein elektrisches Versorgungsnetz ein. Üblicherweise speisen Windenergieanlagen stromprägend in ein elektrisches Versorgungsnetz ein. Das bedeutet besonders, dass ebenfalls mit dem elektrischen Versorgungsnetz gekoppelte Großkraftwerke, die in das elektrische Versorgungsnetz mittels direkt gekoppelter Synchrongeneratoren einspeisen, die Netzspannung des elektrischen Versorgungsnetzes vorgeben. Dabei geben sie auch Frequenz und Phase des elektrischen Versorgungsnetzes vor, nämlich Frequenz und Phase der Netzspannung. Solche Großkraftwerke geben somit die Spannung vor und arbeiten damit spannungsprägend. Das erfolgt besonders auch durch die physikalischen Eigenschaften der Synchrongeneratoren.

Ein gattungsgemäßes Verfahren ist beispielsweise aus dem Dokument WO 2019/120397 A1 bekannt, welches eine Windenergieanlage mit einem Wechselrichter und einem im Zwischenkreis angeordneten Chopper offenbart. Windenergieanlagen orientieren sich bei ihrer Einspeisung an dieser so vorgegebenen Spannung und speisen dazu passend einen elektrischen Einspeisestrom ein. Die Spannung spielt hierbei keine oder eine untergeordnete Rolle. Es kommt in Betracht, dass zur Beeinflussung der Spannung eine Blindstromkomponente eingestellt oder verändert wird, eine Vorgabe der Spannung als oberstes Regelungsziel erfolgt jedoch nicht. Vielmehr wird besonders elektrische Leistung in ihrer Höhe abhängig davon eingespeist, wie viel Leistung aufgrund der Windverhältnisse verfügbar ist. Lediglich in Sondersituationen kommt in Betracht, die Wirkleistung zu verändern.

Bei einer spannungsprägenden Einspeisung steht die Vorgabe der einzuspeisenden bzw. im elektrischen Versorgungsnetz bereitzustellenden Spannung im Vordergrund. Die Windenergieanlage versucht also mit einer vorgegebenen Spannungshöhe einzuspeisen und diese Spannungshöhe im elektrischen Versorgungsnetz möglichst zu halten und damit besonders vorzugehen. Hierbei ergibt sich auch ein Einspeisestrom, der aber eher Mittel zum Zweck ist.

Eine spannungsprägende Einspeisung und eine stromprägende Einspeisung sind jeweils Fachbegriffe mit der vorstehend erläuterten Bedeutung.

Bisher war es nicht üblich, mit Windenergieanlagen spannungsprägend einzuspeisen, weil eine solche spannungsprägende Einspeisung in ein spannungsgeführtes elektrisches Versorgungsnetz bei Spannungsschwankungen im elektrischen Versorgungsnetz mit hohen Schwankungen der Wirkleistung einhergehen kann. Solche Leistungsschwankungen sind bei Windenergieanlagen unerwünscht und aufgrund des Windes als primärer Energiequelle auch nur begrenzt verfügbar.

Dennoch nehmen Windenergieanlagen in manchen Ländern bzw. in manchen elektrischen Versorgungsnetzen eine zunehmend wichtige Rolle ein und liefern zunehmend einen größeren Anteil der eingespeisten Leistung des elektrischen Versorgungsnetzes. Daher kann es wünschenswert sein, dass Windenergieanlagen auch spannungsprägend einspeisen oder gegebenenfalls sogar die einzigen Einspeiser sind, die spannungsprägend einspeisen. Das kommt besonders dann in Betracht, wenn in einem elektrischen Versorgungsnetz bzw. einem relevanten Netzabschnitt keine herkömmlichen Großkraftwerke mehr einspeisen, sei es dauerhaft oder temporär.

Ein weiteres Problem, das bei einer spannungsprägenden Einspeisung mittels Windenergieanlagen auftreten kann, ist, dass plötzliche Spannungsschwankungen der Netzspannung zu entsprechend starken und besonders auch zu entsprechend schnellen Änderungen der eingespeisten Wirkleistung der Windenergieanlage führen können. Solche schnellen Leistungsänderungen können zu ähnlich schnellen Änderungen des Drehmomentes des Generators der Windenergieanlage führen. Besonders annähernd sprungförmige Änderungen der eingespeisten Leistung können zu entsprechend sprungförmigen Änderungen oder nahezu sprungförmigen Änderungen des Drehmomentes der Windenergieanlage führen, also des Drehmomentes des Generators. Je nach Höhe eines solchen Drehmomentsprungs oder überhaupt einer schnellen Drehmomentänderung kann dies zu einer mechanischen Belastung oder sogar mechanischen Gefährdung der Windenergieanlage führen.

Der vorliegenden Erfindung liegt somit die Aufgabe zugrunde, zumindest eines der vorstehend genannten Probleme zu adressieren. Insbesondere soll eine Lösung geschaffen werden, bei der eine Windenergieanlage spannungsprägend in das elektrische Versorgungsnetz einspeisen kann, ohne die Windenergieanlage einer mechanischen Überlastung auszusetzen. Zumindest soll zu bisher bekannten Lösungen eine alternative Lösung vorgeschlagen werden.

Erfindungsgemäß wird ein Verfahren nach Anspruch 1 vorgeschlagen. Das Verfahren betrifft somit das Einspeisen elektrischer Leistung in ein eine Netzspannung aufweisendes elektrisches Versorgungsnetz mittels einer Windenergieanlage. Dafür wird eine Windenergieanlage zugrunde gelegt, die einen Generator, einen aktiven Gleichrichter, einen Gleichspannungszwischenkreis mit einem Chopperkreis und einen Wechselrichter aufweist. Mit dem Generator wird ein Generatorstrom erzeugt, nämlich üblicherweise ein Statorstrom. Insoweit wird insbesondere vorgeschlagen, als Generator einen Synchrongenerator zu verwenden. Dieser kann fremderregt sein oder Permanentmagnete aufweisen.

Dieser erzeugte Generatorstrom, also insbesondere Statorstrom, wird mit einem aktiven Gleichrichter in einen Gleichstrom gleichgerichtet, der hier als Gleichrichtstrom bezeichnet wird, und in den Gleichspannungszwischenkreis eingegeben, dort also eingespeist. Der Gleichspannungszwischenkreis nimmt diesen Gleichrichtstrom bzw. die Energie, die dieser mitführt, auf. Der aktive Gleichrichter kann auch als generatorseitiger Wechselrichter bezeichnet werden, denn er stellt einen Zusammenhang zwischen dem Gleichrichtstrom und dem erzeugen Generatorstrom her, wobei lediglich üblicherweise der Energiefluss vom Generator zum Gleichspannungszwischenkreis verläuft. Das kann in Ausnahmesituationen aber auch anders sein. Um Verwechslungen mit dem netzseitigen Wechselrichter zu vermeiden, wird hier von einem aktiven Gleichrichter gesprochen.

Dieser aktive Gleichrichter richtet den erzeugten Generatorstrom somit gezielt gleich und kann dabei auch die Zwischenkreisspannung des Gleichspannungszwischenkreises steuern bzw. ausregeln. Außerdem kann mit dem aktiven Gleichrichter auch der erzeugte Generatorstrom, also insbesondere der Statorstrom des Generators, gesteuert werden. Mit dem aktiven Gleichrichter ist somit auch das Drehmoment des Generators steuerbar, zumindest beeinflussbar. Ist der Generator als permanent erregter Synchrongenerator ausgebildet, so erfolgt im Grunde die Steuerung des elektrischen Drehmomentes des Generators über den Statorstrom und damit durch den aktiven Gleichrichter.

Mit dem Gleichspannungszwischenkreis ist ein Wechselrichter verbunden, um einen Einspeisestrom zum Einspeisen in das elektrische Versorgungsnetz zu erzeugen. Somit bildet dieser Wechselrichter einen netzseitigen Wechselrichter, weil er mit dem elektrischen Versorgungsnetz verbunden ist, wobei weitere Elemente, wie z.B. ein Transformator, zwischengeschaltet sein können. Soweit nachfolgend von einem Wechselrichter die Rede ist, ist grundsätzlich dieser netzseitige Wechselrichter gemeint, wohingegen der genannte generatorseitige Wechselrichter als aktiver Gleichrichter bezeichnet wird.

Es wird dann vorgeschlagen, dass das Einspeisen spannungsprägend erfolgt. Der Wechselrichter wirkt also einer Abweichung der Netzspannung von einem Spannungssollwert durch eine Anpassung des eingespeisten Stroms entgegen. Dazu kann eine Ausgangsspannung an Ausgangsklemmen des Wechselrichters vorgegeben werden und die spannungsprägende Einspeisung regelt diese Spannung an den Ausgangsklemmen aus, und daraus ergibt sich eine Höhe des Stroms, also das Einspeisestroms. Es ergibt sich somit ein Strom aufgrund der direkt geregelten Ausgangsspannung, das kann auch so bezeichnet werden, dass die Spannung an den Klemmen festgehalten wird. Besonders erfolgt ein Ausregeln der Spannung mit stationärer Genauigkeit. Das Ausregeln der Spannung ist das vorrangige Regelungsziel. Eine spannungsprägende Einspeisung bezeichnet besonders eine Einspeisung, bei der der Einspeiser, hier also die Windenergieanlage, die eingespeiste Spannung auch der Höhe nach führt.

Dazu wird nun vorgeschlagen, dass der aktive Gleichrichter eine untere Strombegrenzung aufweist, die auch einfach als Strombegrenzung oder Gleichstrombegrenzung bezeichnet werden kann, um bei einer Änderung der Netzspannung in Amplitude und/oder Phasenlage einen Abfall des Gleichrichtstroms zum Schutz des Generators zu begrenzen. Zur Umsetzung kann die Höhe des Gleichrichtstromes oder auch des gleichzurichtenden Generatorstroms, insbesondere Statorstromes, überwacht werden. Hier wurde besonders erkannt, dass ein Spannungsanstieg der Netzspannung oder eine Winkeländerung der Netzspannung, besonders hin zum Spannungswinkel an den Ausgangsklemmen der Windenergieanlage, zu einer Reduzierung der eingespeisten Wirkleistung führt. Das wirkt sich auf den Gleichspannungszwischenkreis aus und das wiederum kann dazu führen, dass der Gleichrichtstrom reduziert wird. Eine zu starke Reduzierung des Gleichrichtstroms kann durch die untere Strombegrenzung vermieden werden, wodurch mechanische Überlastungen durch eine zu schnelle Drehmomentveränderung des Generators vermieden wird. Die untere Strombegrenzung begrenzt somit auch eine Generatorleistung und auch einen Generatorstrom, insbesondere Statorstrom. Gleichwirkend kann auch die Generatorleistung, der Generatorstrom oder der Statorstrom durch eine untere Grenze begrenzt werden. Das entspricht sinngemäß der Begrenzung des Gleichrichtstromes durch die untere Strombegrenzung, denn der Gleichrichtstrom wird dadurch auch begrenzt.

Dabei wird vorgeschlagen, dass die untere Strombegrenzung in Abhängigkeit von einem Betriebspunkt der Windenergieanlage eingestellt und verändert wird. Insbesondere erfolgt dies in Abhängigkeit von einem Betriebspunkt des aktiven Gleichrichters.

Ein anschauliches Beispiel, das aber auch eine relevante Ausführungsform beschreibt, besteht darin, die untere Strombegrenzung zunächst so einzustellen, dass sie um 5 bis 15%, insbesondere 10 %, bezogen auf einen maximalen Gleichrichtstrom oder einen Nenngleichrichtstrom, unterhalb des aktuellen Gleichrichtstroms liegt, zumindest zu Beginn einer Änderung des Gleichrichtstromes dieser Höhe.

Durch die untere Strombegrenzung soll eine zu starke Änderung des Drehmomentes des Generators vermieden werden. Daher wird vorgeschlagen, die untere Strombegrenzung mit der Zeit aber weiter zu verändern, besonders, wenn der Gleichrichtstrom die untere Strombegrenzung erreicht hat, also insbesondere auf den aktuellen Wert der unteren Strombegrenzung abgefallen ist. Diese untere Strombegrenzung des aktiven Gleichrichters wird hier als Gleichrichtstrombegrenzung bezeichnet. Ist sie erreicht, kann sie aber weiter verändert werden, insbesondere weiter abgesenkt werden, um bei Bedarf eine weitere Verringerung des Gleichrichtstroms zu erlauben. Wichtig ist nur, dass der Gleichrichtstrom keine zu starken Änderungen in einer vorbestimmten Zeit aufweist.

Äquivalent kann auch der Generatorstrom, insbesondere der Statorstrom, begrenzt werden, was dieselbe Wirkung haben kann wie den Gleichrichtstrom zu begrenzen, jedenfalls dann, wenn sich die Begrenzung des Generatorstroms, der ein Wechselstrom ist, auf den Wirkanteil des erzeugten Generatorstroms bezieht. Insoweit ist die Umsetzung einfacher, den Gleichrichtstrom zu begrenzen; den erzeugten Generatorstrom in der genannten Art und Weise zu begrenzen führt aber dem Grunde nach zum selben Ergebnis.

Außerdem wird vorgeschlagen, dass der Chopperkreis so gesteuert wird, dass er überschüssige Energie, die durch die untere Strombegrenzung des aktiven Gleichrichters in dem Gleichspannungszwischenkreis auftritt, oder ein Teil davon, aus dem Gleichspannungszwischenkreis abführt. Hier wurde besonders erkannt, dass die untere Strombegrenzung des aktiven Gleichrichters, also die Gleichrichtstrombegrenzung, dazu führen kann, dass überschüssige Energie in dem Gleichspannungszwischenkreis auftritt. Dieses Auftreten der überschüssigen Energie kann besonders bedeuten, dass der Generator mehr Energie bzw. mehr Leistung in den Gleichspannungszwischenkreis einspeist als in das elektrische Versorgungsnetz eingespeist wird. Diese Energie kann durch den Chopperkreis abgeführt werden.

Der Chopperkreis arbeitet dabei besonders so, dass er durch ein gepulstes Verfahren von dem Gleichspannungszwischenkreis einen gepulsten Strom durch entsprechende Schaltung von einem oder mehreren Halbleiterschaltern durch einen Chopperwiderstand erzeugt. Die abgeführte Energie wird in dem Chopperwiderstand dabei in Wärme umgewandelt.

Besonders kann hierdurch erreicht werden, dass auch sehr starke Stromänderungen des eingespeisten Wirkstroms möglich sind, um einer ansteigenden Netzspannung, einer Veränderung des Netzphasenwinkels oder eine Beschleunigung der Netzfrequenz entgegenzuwirken. Dabei kann eine mechanische Überlastung der Windenergieanlage, besonders eine zu starke und zu schnelle Veränderung des Generatormoments, vermieden werden. Gleichzeitig ist nur ein geringer apparativer Aufwand, möglicherweise kein zusätzlicher apparativer Aufwand, nötig, um diese spannungsprägende Einspeisung zu realisieren. Insbesondere kann ein zusätzlicher Energiespeicher, wie Batteriebänke, oder andere elektrische Energiespeicher, die über einen Zwischenkreiskondensator hinausgehen, vermieden werden.

Gemäß einer Ausführungsform wird vorgeschlagen, dass der Chopperkreis Energie aus dem Gleichspannungszwischenkreis abführt, sobald die Zwischenkreisspannung eine Auslösespannung erreicht hat. Der Chopperkreis kann damit auf einfache Art und Weise realisiert werden, indem er die Zwischenkreisspannung überwacht. Wird sie zu groß, beginnt der Chopperkreis, Energie abzuführen, was auch als Choppern bezeichnet werden kann.

Dies wirkt zusammen mit einem aktiven Gleichrichter, der durch das Steuern des Gleichrichtstroms die Zwischenkreisspannung regelt, um die Zwischenkreisspannung auf einen Wert oder einen Bereich unterhalb der Auslösespannung zu regeln. Im Normalfall regelt der aktive Gleichrichter also die Zwischenkreisspannung auf einen gewünschten Wert oder zumindest gewünschten Spannungsbereich ein. Die Auslösespannung wird dabei nicht erreicht und der Chopperkreis bleibt somit inaktiv.

Es wird aber weiter vorgeschlagen, dass das Verfahren so funktioniert, dass dann, wenn der Gleichrichtstrom die Gleichrichtstrombegrenzung erreicht hat und dadurch beschränkt wird, die Zwischenkreisspannung weiter ansteigt. Diese steigt daraufhin an, bis sie die Auslösespannung erreicht hat. Das führt schließlich dazu, dass der Chopperkreis anspricht und Energie aus dem Gleichspannungszwischenkreis abführt.

Es wurde erkannt, dass ein Chopperkreis grundsätzlich dazu ausgelegt ist, Energie aus einem Gleichspannungszwischenkreis abzuführen. Erreicht der Gleichspannungszwischenkreis die Auslösespannung, setzt dieses Abführen der Energie ein und wirkt dabei auch einem weiteren Anstieg der Zwischenkreisspannung in dem Gleichspannungszwischenkreis entgegen.

Durch den bevorzugten aktiven Gleichrichter, der die Zwischenkreisspannung regelt, kann die Zwischenkreisspannung im Grunde ohne Energieverlust auf dem gewünschten Spannungswert oder in dem gewünschten Spannungsbereich, also Spannungsband, gehalten werden. Dies ist eine gute Basis für den netzseitigen Wechselrichter, davon elektrische Leistung in das elektrische Versorgungsnetz einzuspeisen.

Es wurde aber erkannt, dass dieser ansonsten vorteilhafte aktive Gleichrichter im Falle der spannungsprägenden Einspeisung zu einer mechanischen Belastung des Generators führen kann. Durch die spannungsprägende Einspeisung kann es bei entsprechenden Spannungsänderungen der Netzspannung zu entsprechend schnellen und starken Änderungen der eingespeisten Wirkleistung kommen. Dies macht sich im Gleichspannungszwischenkreis bemerkbar und der aktive Gleichrichter versucht dies auszuregeln. Verringert sich also die eingespeiste Wirkleistung, verringert sich der Einspeisestrom bzw. der Wirkanteil des Einspeisestroms. Durch das Ausregeln der Zwischenkreisspannung verringert sich somit auch durch den aktiven Gleichrichter der Gleichrichtstrom und damit auch der Generatorstrom bzw. Statorstrom. Das führt zu einer entsprechenden Verringerung des Generatormomentes. Erfolgen diese Vorgänge schnell, also insbesondere sprunghaft, so stellt sich auch eine entsprechend schnelle bzw. sprunghafte Änderung des Generatormomentes ein.

Der Chopperkreis kann dies nicht verhindern und bleibt inaktiv, weil der aktive Gleichrichter die Zwischenkreisspannung ausregelt und damit die Auslösespannung nicht erreicht wird.

Dieses Problem wurde erkannt und daher wird vorgeschlagen, dass der Gleichrichtstrom begrenzt wird, nämlich durch eine untere Gleichrichtstrombegrenzung. Der Gleichrichtstrom und damit der erzeugte Generatorstrom bzw. Statorstrom kann durch die untere Gleichrichtstrombegrenzung nicht so stark abfallen wie sich ansonsten aufgrund der Änderung der eingespeisten Wirkleistung ergeben würde. Der Generator erzeugt also mehr Leistung und damit mehr Energie als aufgrund der eingespeisten Wirkleistungsverringerung in das elektrische Versorgungsnetz eingespeist wird. Die Energie im Gleichspannungszwischenkreis steigt an und damit die Zwischenkreisspannung, bis diese die Auslösespannung erreicht hat. Die vorgeschlagene Gleichrichtstrombegrenzung führt somit zu dieser Erhöhung der Zwischenkreisspannung und damit zum Auslösen des Chopperkreises. Dadurch ergibt sich ein Zusammenspiel zwischen dem aktiven Gleichrichter und dem Chopperkreis. Dieses Zusammenspiel ist so, dass der aktive Gleichrichter eine zu starke Änderung des Generatormomentes verhindert, während der Chopperkreis die dabei auftretende überschüssige Energie abführt.

Gemäß einer Ausführungsform wird vorgeschlagen, dass der Chopperkreis eine Chopperstatik aufweist, die einen Zusammenhang zwischen einem die Auslösespannung überschreitenden Spannungswert der Zwischenkreisspannung und eine aus dem Gleichspannungszwischenkreis abzuführenden Leistung angibt, die hier als Chopperleistung bezeichnet wird. Insbesondere kann die Chopperstatik diesen Zusammenhang als linearen Zusammenhang aufweisen. Je stärker die Auslösespannung also von der Zwischenkreisspannung überschritten wird, umso mehr Leistung wird durch den Chopperkreis abgeführt.

Dadurch kann erreicht werden, dass die Zwischenkreisspannung die Auslösespannung überschreiten kann und noch weiter ansteigen kann. Wie weit die Zwischenkreisspannung dann oberhalb der Auslösespannung liegt, lässt einen Rückschluss darauf zu, wie viel Leistung der Chopperkreis in diesem Moment abführt. Dann kann beispielsweise der netzseitige Wechselrichter abhängig von der Zwischenkreisspannung, insbesondere abhängig von dem Spannungswert, um den die Zwischenkreisspannung die Auslösespannung überschreitet, die eingespeiste Wirkleistung steuern, bzw. die Ausgansspannung in Amplitude, Phasenlage und Frequenz so anpassen, dass sich die Wirkleistung entsprechend anpasst.

Beispielsweise kommt in Betracht, dass eine sprunghafte Erhöhung der Netzspannung oder sprunghaft Veränderung der Netzphase zu einer sprunghaften Verringerung der eingespeisten Wirkleistung führt, was wiederum zu einer Begrenzung des Gleichrichtstroms nach unten geführt haben kann, mit der Folge, dass die Zwischenkreisspannung ansteigt und der Chopperkreis auslöst. Ändert sich nun die Netzspannung sprunghaft wieder zurück, so würde dies zu einer sprunghaften Erhöhung der eingespeisten Wirkleistung führen. Das kann ebenfalls zu einer Belastung des Generators führen, wenn diese sprunghafte Leistungserhöhung sich entsprechend bis zum Generator hin, also bis zu seinem Drehmoment hin, auswirkt. In diesem Fall könnte diese Leistungserhöhung der eingespeisten Wirkleistung begrenzt sein. Ist aber erkennbar, dass der Chopperkreis eine hohe Leistung abführt, so kann die genannte Begrenzung der Erhöhung der eingespeisten Wirkleistung entbehrlich sein oder kleiner ausfallen. Wenigstens könnte die eingespeiste Wirkleistung ohne Weiteres um den Betrag erhöht werden, um den der Chopperkreis Wirkleistung aus dem Gleichspannungszwischenkreis abführt.

In der Umsetzung kann dies lediglich bedeuten, dass der netzseitige Wechselrichter seine eingespeiste Wirkleistung umso stärker erhöhen darf, insbesondere umso stärker sprunghaft erhöhen darf, je höher die Zwischenkreisspannung ist.

Gemäß einer Ausführungsform wird vorgeschlagen, dass
- zum Regeln der Zwischenkreisspannung eine Regelungsvorschrift, insbesondre eine Regelungsstatik, vorgesehen ist, und die Regelungsvorschrift sich zusammensetzt aus
- einer Gleichrichterregelung, insbesondere einer Gleichrichterstatik, und einer Chopperregelung, insbesondere einer bzw. der Chopperstatik, wobei
- die Gleichrichterregelung einen Zusammenhang vorgibt zwischen der Zwischenkreisspannung und dem durch den aktiven Gleichrichter einzustellenden Gleichrichtstrom, derart, dass
- der einzustellende Gleichrichtstrom mit ansteigender Zwischenkreisspannung abfällt, insbesondere linear abfällt, bis der Gleichrichtstrom die untere Strombegrenzung erreicht hat, und
- der einzustellende Gleichrichtstrom bei weiter steigender Zwischenkreisspannung auf dieser unteren Strombegrenzung gehalten wird, und
- die Chopperregelung einen Zusammenhang vorgibt zwischen der Zwischenkreisspannung und einer bzw. der durch den Chopperkreis aus dem Zwischenkreis abzuführenden Chopperleistung, derart, dass
- die Chopperleistung mit zunehmender Zwischenkreisspannung zunimmt, sobald die Zwischenkreisspannung eine bzw. die Auslösespannung überschreitet, wobei
- die untere Strombegrenzung und/oder die Auslösespannung veränderbar sind und insbesondere in Abhängigkeit eines Arbeitspunktes der Windenergieanlage verändert werden.

Die Zwischenkreisregelung wird somit aus einem Zusammenspiel von Gleichrichterregelung und Chopperregelung gebildet. Sowohl die Gleichrichterregelung als auch die Chopperregelung können jeweils als Statik ausgebildet sein, bei der der Zusammenhang zwischen Zwischenkreisspannung und Gleichrichtstrom bzw. Zwischenkreisspannung und Chopperleistung linear ausgebildet ist, also jeweils als Gerade mit vorbestimmter Steigung, zumindest abschnittsweise.

Jedenfalls steuert die Gleichrichterregelung den einzustellenden Gleichrichtstrom in Abhängigkeit der Zwischenkreisspannung, nämlich so, dass der Gleichrichtstrom um so kleiner ist, je größer die Zwischenkreisspannung. Bis zur unteren Strombegrenzung. Damit wird auch die Generatorleistung gesteuert und damit auch das Generatormoment. Durch die untere Strombegrenzung kann das Generatormoment begrenzt werden, bzw. ein zu starkes Abfallen des Generatordrehmomentes kann begrenzt werden. Alternativ kann die Gleichrichterregelung auch statt dem Gleichrichtstrom die Generatorleistung direkt steuern und entsprechend eine untere Leistungsbegrenzung vorgeben. Das ist gleichwirkend.

Steigt die Zwischenkreisspannung nun weiter an, wird der Gleichrichtstrom bzw. die Generatorleistung nicht mehr abgesenkt und damit wird dem weiteren Anstieg der Zwischenkreisspannung nicht weiter entgegengewirkt. Nun kann die Chopperregelung übernehmen und als Chopperleistung Leistung aus dem Zwischenkreis abführen, um dadurch einem weiteren Anstieg der Zwischenkreisspannung entgegenzuwirken. Da die Chopperleistung abgeführte Leistung ist, nimmt sie, also ihr Betrag, mit weiter steigender Zwischenkreisspannung zu, soweit die Zwischenkreisspannung die Auslösespannung überschreitet. Liegt die Zwischenkreisspannung unter der Auslösespannung, bleibt der Chopperkreis inaktiv.

Da aber nicht das Drehmoment des Generators absolut beschränkt werden soll, sondern nur eine zu schnelle und zu starke Änderung, wird vorgeschlagen, die untere Strombegrenzung und die Auslösespannung veränderbar zu machen, insbesondere dynamisch veränderbar zu machen.

Das sollte möglichst von einem Arbeitspunkt der Windenergieanlage abhängen, insbesondere von dem Gleichrichtstrom. Hierdurch kann die untere Stromgrenze dem Gleichrichtstrom nachgeführt werden, aber so, dass Änderungen des Gleichrichtstromes weiterhin möglich bleiben, aber in Grenzen. Dabei wird nicht nur das Verhalten der Gleichrichterregelung entsprechend angepasst, sondern auch das der Chopperregelung.

Es wurde nun erkannt, dass die Gleichrichterregelung und die Chopperregelung vorteilhaft aufeinander abgestimmt werden können, wenn die Auslösespannung in Abhängigkeit von der unteren Strombegrenzung eingestellt wird, insbesondere, wenn sie dieser quasi nachgeführt wird. Dabei wurde erkannt, dass die Generatorleistung und damit das Generatormoment zwar über die untere Stromgrenze dynamisch beschränkt werden kann, dass daran angepasst die Chopperregelung aber gut durch eine Veränderung der Auslösespannung daran angepasst werden kann.

Besonders wird vorgeschlagen, dass
- die untere Strombegrenzung und die Auslösespannung in Abhängigkeit voneinander verändert werden, insbesondere so, dass
- die Auslösespannung in Abhängigkeit von der unteren Strombegrenzung eingestellt wird und bei Änderungen der unteren Strombegrenzung ebenfalls geändert wird, und/oder
- die Auslösespannung auf einen Zwischenkreisreferenzwert gesetzt wird, den die Zwischenkreisspannung erreicht, wenn der Gleichrichtstrom auf die Strombegrenzung abgefallen ist, und/oder die Auslösespannung in Abhängigkeit des Zwischenkreisreferenzwertes eingestellt wird, insbesondere auf einen Wert, der um weniger als 5% von dem Zwischenkreisreferenzwert abweicht.

Durch die untere Strombegrenzung, besonders bei einem linearen Zusammenhang der Gleichrichterregelung, ergibt sich eine zugehörige Zwischenkreisspannung, die hier als Zwischenkreisreferenzwert bezeichnet wird. Auf diese kann die Auslösespannung gesetzt werden. Dadurch wird erreicht, dass die Regelung der Zwischenkreisspannung von der Gleichrichtregelung auf die Chopperregelung übergeht, wenn die Zwischenkreisspannung den Zwischenkreisreferenzwert übersteigt. Die Auslösespannung wird dazu auf den Zwischenkreisreferenzwert gelegt, sie kann davon aber geringfügig abweichen, was hier mit 5% beziffert ist. Besonders ist vorgesehen, dass sie bis zu 5% oberhalb des Zwischenkreisreferenzwertes liegt.

Gemäß einer Ausführungsform wird vorgeschlagen, dass die untere Strombegrenzung des aktiven Gleichrichters als dynamische Funktion in Abhängigkeit von dem aktuellen Gleichrichtstrom ausgebildet ist. Die untere Strombegrenzung ist also kein fester Wert, sondern hängt von dem aktuellen Gleichrichtstrom, also dem aktuellen Gleichstromwert, ab. Hier wurde besonders erkannt, dass es nicht auf eine absolute Begrenzung des Gleichrichtstroms ankommt, sondern dass eine zu starke Veränderung vermieden werden soll.

Insbesondere ist die untere Strombegrenzung des aktiven Gleichrichters so ausgebildet, dass sie im stationären Fall um eine Unterschreitungsgrenze unter dem aktuellen Gleichstrom liegt und im Falle eines Abfalls des Gleichrichtstroms dem Gleichrichtstrom abzüglich der Unterschreitungsdifferenz mit einer dynamischen Funktion nachgeführt wird. Im stationären Fall liegt die untere Strombegrenzung des aktiven Gleichrichters also unterhalb des aktuellen Gleichrichtstroms. Wenn sich der Gleichrichtstrom dann plötzlich ändert, weil sich die Netzspannung plötzlich geändert hat und der netzseitige Wechselrichter dadurch durch eine plötzliche Leistungsänderung reagiert, so kann sich auch der Gleichrichtstrom sofort, schnell und auch sprunghaft ändern. Die Gleichrichtstrombegrenzung behindert insoweit nicht die Dynamik dieser Netzreaktion.

Diese schnelle Änderung, die auch für den Gleichrichtstrom und damit den erzeugten Generatorstrom bzw. Statorstrom zugelassen wird, ist aber begrenzt, nämlich in ihrer sprunghaften Amplitude auf die Unterschreitungsdifferenz. Der Gleichrichtstrom kann also spontan maximal um die Unterschreitungsdifferenz abfallen.

Fällt der Gleichrichtstrom ab, insbesondere um die Unterschreitungsdifferenz, so passt sich die untere Strombegrenzung des aktiven Gleichrichters daran an, allerdings nicht sofort, sondern mit einer dynamischen Funktion. Hier ist besonders vorgesehen, dass die dynamische Funktion ein Tiefpassverhalten aufweist, insbesondere ein PT1-Verhalten, also ein Verhalten gemäß einem Verzögerungsglied erster Ordnung.

Zur Erläuterung sei folgendes Beispiel genannt. Verringert sich die eingespeiste Leistung sprunghaft um beispielsweise 50 %, so würde sich auch der Gleichrichtstrom um 50 % verringern wollen. Wird beispielsweise als Unterschreitungsdifferenz ein Wert von 10 % angesetzt, bezogen auf einen Nennwert des Gleichrichtstroms, so kann sich der Gleichrichtstrom sofort um 10 % verringern, denn die untere Strombegrenzung des aktiven Gleichrichters liegt hier anfangs auf einem Wert von 10 % unter dem Anfangswert des Gleichrichtstroms. Der Gleichrichtstrom liegt also nun bei 10 % unterhalb seines Anfangswertes und will sich noch weiter verringern. Jetzt setzt das Nachführen mit der dynamischen Funktion ein. Hier kann beispielsweise angenommen werden, dass die dynamische Funktion ein PT1-Verhalten aufweist. Diese dynamische Funktion führt nun die untere Strombegrenzung des aktiven Gleichrichters dem aktuellen Gleichrichtstrom abzüglich der Unterschreitungsdifferenz nach. Sie führt also die untere Strombegrenzung mit einem PT1-Verhalten von 10 % unter dem Anfangswert auf 20 % unter dem Anfangswert.

Da der Gleichrichtstrom aber weiter abfallen will, folgt er dieser unteren Strombegrenzung die mit dem Tiefpassverhalten nachgeführt wird. Somit fällt also auch der Wert, der sich aus dem aktuellen Gleichrichtstromwert abzüglich der Unterschreitungsdifferenz zusammensetzt. Die untere Strombegrenzung wird also durch das PT1-Verhalten einem kontinuierlich weiter fallenden Wert nachgeführt. Daraus ergibt sich eine konstante Steigung, mit der die untere Strombegrenzung abfällt.

Dieses Verhalten ändert sich dann, wenn der Gleichrichtstrom den oben angenommenen Endwert von 50 % unter seinem Anfangswert erreicht hat. Dann fällt der Gleichrichtstrom nicht mehr weiter ab und die untere Strombegrenzung wird von diesem Wert von 50 % unterhalb des Anfangswertes gemäß einem PT1-Verhalten auf den Endwert von 60 % unterhalb des Anfangswertes des Gleichrichtstroms geführt.

Vorzugsweise verhält sich die untere Strombegrenzung bei wieder ansteigendem Gleichrichtstrom aber anders. Beispielsweise kann das Verhalten ähnlich, aber mit einer viel geringeren Zeitkonstante des PT1-Verhaltens ausgebildet sein. Idealerweise folgt die untere Strombegrenzung bei ansteigendem Gleichrichtstrom unmittelbar dem Wert, der sich aus dem aktuellen Gleichrichtstrom abzüglich der Unterschreitungsdifferenz zusammensetzt. Das wird bevorzugt vorgeschlagen, um zu verhindern, dass der Gleichrichtstrom wieder ansteigt, die untere Strombegrenzung aufgrund des PT1-Verhaltens aber nicht schnell genug nachgeführt wird, dann der Gleichrichtstrom plötzlich wieder abfällt und dadurch plötzlich einen größeren Abstand zur untere Strombegrenzung hat als die Unterschreitungsdifferenz. Daher sollte beim Ansteigen des Gleichrichtstroms diese Dynamik nicht angewendet werden, sondern entweder eine deutlich schnellere oder gar keine Dynamik, sondern ein unmittelbares Folgen dieses aktuellen Gleichrichtstromwertes abzüglich der Unterschreitungsdifferenz.

Gemäß einer Ausführungsform wird vorgeschlagen, dass der Wechselrichter, also der netzseitige Wechselrichter, eine obere Wechselrichterstrombegrenzung aufweist, um bei einem Spannungsabfall der Netzspannung einen Anstieg des Einspeisestroms zum Schutz des Generators nach oben zu begrenzen. Der Einspeisestrom kann sich grundsätzlich aus einem Wirk- und einem Blindanteil zusammensetzen, hier kommt es aber nur auf den Wirkanteil an und insoweit kann der Einspeisestrom auch als eingespeister Wirkstrom verstanden werden bzw. dass der Anstieg des Einspeisestroms nur den Wirkanteil begrifft. Mit anderen Worten wird vorgeschlagen, dass der Anstieg des eingespeisten Wirkstroms bzw. der Anstieg des Wirkanteils des Einspeisestroms nach oben begrenzt wird.

Hier wurde besonders erkannt, dass bei einem Spannungsabfall der Netzspannung eine Begrenzung der mechanischen Belastung der Windenergieanlage, also insbesondere eine Begrenzung des Generatordrehmomentes durch eine Begrenzung des Einspeisestroms erreicht werden kann. Auch hier ist grundsätzlich eine Erhöhung des Einspeisestroms zugelassen, auch sprunghaft, aber nur bis zu einem vorbestimmten Wert.

Vorzugsweise wird diese obere Wechselrichterstrombegrenzung in Abhängigkeit von einem Betriebspunkt der Windenergieanlage eingestellt und verändert, insbesondere in Abhängigkeit von einem Betriebspunkt des Wechselrichters und/oder in Abhängigkeit von einem Betriebspunkt der Zwischenkreisspannung. Besonders wird vorgeschlagen, dass die Wechselrichterstrombegrenzung abhängig von dem Einspeisestrom eingestellt und verändert wird. Auch hier kommt eine dynamische Veränderung in Betracht und es wurde erkannt, dass besonders eine sprunghafte Erhöhung zu begrenzen ist. Eine weitere Erhöhung, sofern sie nicht zu sprunghaft bzw. nicht mit einer zu großen Steigung erfolgt, kann hierdurch zugelassen werden.

Außerdem oder alternativ kann auch die Zwischenkreisspannung berücksichtigt werden. Ist sie hoch, kann eine höhere Wechselrichterstrombegrenzung gewählt werden, es kann dann also eine stärkere Änderung des Einspeisestroms und damit der eingespeisten Wirkleistung zugelassen werden. Wie oben schon erläutert, kann hier nämlich berücksichtigt werden, dass bei einer hohen Zwischenkreisspannung eine Erhöhung der Leistungseinspeisung zunächst nur zu einer Reduzierung bis zu einem Wegfall einer durch den Chopperkreis abgeführten Leistung führt. Das führt nicht zu einer Drehmomentbelastung und braucht daher nicht begrenzt zu werden. Die obere Wechselrichterstrombegrenzung kann dies also berücksichtigen und entsprechend höher liegen.

Vorzugsweise wird vorgeschlagen, dass die obere Wechselrichterstrombegrenzung als dynamische Funktion in Abhängigkeit von dem aktuellen Einspeisestrom ausgebildet ist. Sie ist also nicht fest, sondern passt sich dem aktuellen Einspeisestrom an.

Insbesondere ist die Wechselrichterstrombegrenzung so ausgebildet, dass sie im stationären Fall um eine Überschreitungsdifferenz über dem aktuellen Einspeisestrom liegt. Damit ist also in jedem Fall eine Erhöhung des Einspeisestroms und damit eine Erhöhung der eingespeisten Wirkleistung sofort möglich, aber nur bis zu diesem Wert der Überschreitungsdifferenz.

Im Falle eines Anstiegs des Einspeisestroms wird die Wechselrichterstrombegrenzung dem Einspeisestrom zuzüglich der Überschreitungsdifferenz mit einer dynamischen Funktion nachgeführt. Auch hier, wie bei der unteren Strombegrenzung des aktiven Gleichrichters, wird eine dynamische Funktion vorgeschlagen, die ein Tiefpassverhalten aufweist, insbesondere ein PT1-Verhalten. Die dazu beschriebene Erläuterung zur unteren Strombegrenzung des aktiven Gleichrichters gilt hier sinngemäß für einen Anstieg des Einspeisestroms. Auch hier wird sinngemäß vorgeschlagen, dass bei einem Abfall des Einspeisestroms keine Nachführung über dasselbe PT1-Verhalten erfolgt, sondern entweder eine Nachführung mit schneller Dynamik, oder eine unmittelbare Nachführung ohne dynamisches Verhalten.

Vorzugsweise hängt die Überschreitungsdifferenz von der Zwischenkreisspannung ab. Insbesondere kann sie sich additiv zusammensetzen aus einem Wert, der von der Zwischenkreisspannung abhängt, und einem weiteren, beispielsweise fest vorgebbaren Wert. Insbesondere wird vorgeschlagen, dass die Überschreitungsdifferenz von einem Überschreitungswert abhängt, um den die Zwischenkreisspannung die Auslösespannung überschreitet. Die Auslösespannung ist also diejenige Spannung, bei der der Chopperkreis anspricht und Leistung abführt. Je höher die Zwischenkreisspannung über dieser Auslösespannung liegt, umso größer kann die Überschreitungsdifferenz gewählt werden.

Vorzugsweise setzt sich die Überschreitungsdifferenz additiv zusammen aus einem ersten und einem zweiten Teilwert. Der erste Teilwert hängt von dem Wechselrichter ab und/oder ist vorgebbar, und der zweite Teilwert hängt von der Zwischenkreisspannung ab. Vorzugsweise ist der zweite Teilwert proportional zu einem Überschreitungswert, um den die Zwischenkreisspannung die Auslösespannung überschreitet.

Gemäß einer Ausführungsform wird vorgeschlagen, dass eine Erhöhung einer eingespeisten Wirkleistung auf einen Wert im Bereich von 5 % bis 20 % oberhalb der eingespeisten Wirkleistung bezogen auf die eingespeiste Wirkleistung oder bezogen auf eine Nennleistung der Windenergieanlage begrenzt wird. Gleichzeitig wird vorgeschlagen, dass eine Verringerung der eingespeisten Wirkleistung bis zu einem Wert von -100 % bezogen auf die eingespeiste Wirkleistung oder bezogen auf die Nennleistung der Windenergieanlage zugelassen wird. Die Wirkleistung kann also um 5 bis 20 % erhöht werden, oder sie kann so weit verringert werden, dass die Windenergieanlage Wirkleistung aus dem elektrischen Versorgungsnetz entnimmt, nämlich bis zu dem Wert, bis zu dem sie eingespeist hatte oder sogar bis zu dem Wert, der ihrer Nennleistung entspricht.

Hier wurde besonders erkannt, dass eine spannungsprägende Einspeisung auch ohne großen Energiespeicher, also ohne eine Batteriestation, möglich ist, wenn entsprechende Grenzen gesetzt werden. Dabei wurde erkannt, dass eine Wirkleistungserhöhung nur in geringerem Umfang möglich ist, wohingegen aber eine Verringerung der eingespeisten Wirkleistung in hohem Maße auch ohne diesen großen Energiespeicher möglich ist. Diese Verringerung kann sogar so weit gehen, dass Wirkleistung in Höhe von Nennleistung der Windenergieanlage aus dem elektrischen Versorgungsnetz entnommen wird.

Eine mechanische Überlastung der Windenergieanlage wird dabei durch die beschriebenen Maßnahmen vermieden.

Erfindungsgemäß wird auch eine Windenergieanlage vorgeschlagen. Diese Windenergieanlage ist so ausgestaltet wie dies vorstehend im Zusammenhang mit den Erläuterungen des Verfahrens zum Einspeisen erläutert wurde. Die Windenergieanlage weist dabei eine Anlagensteuerung auf, die dazu vorbereitet ist, das Einspeisen entsprechend zu steuern. Dazu kann die Anlagensteuerung einen entsprechenden Prozessrechner aufweisen, der besonders den netzseitigen Wechselrichter, den Chopperkreis und/oder den aktiven Gleichrichter ansteuern kann.

Insbesondere wird vorgeschlagen, dass die Windenergieanlage dazu vorbereitet ist, insbesondere, dass ihre Anlagensteuerung dazu vorbereitet ist, ein Verfahren gemäß einer der vorstehend beschriebenen Ausführungsformen auszuführen.

Nachfolgend wird die Erfindung anhand von Ausführungsformen unter Bezugnahme auf die begleitenden Figuren näher erläutert.
- Fig. 1: zeigt eine Windenergieanlage in einer perspektivischen Darstellung.
- Fig. 2: zeigt schematisch einen elektrischen Leistungspfad einer Windenergieanlage vom Generator bis zum elektrischen Versorgungsnetz.
- Fig. 3: zeigt ein Diagramm mit zwei Teildiagrammen zum Erläutern des vorgeschlagenen Verfahrens für eine Erhöhung des Einspeisestroms.
- Fig. 4: zeigt ein Diagramm mit zwei Teildiagrammen zum Erläutern des vorgeschlagenen Verfahrens für eine Verringerung des Einspeisestroms.

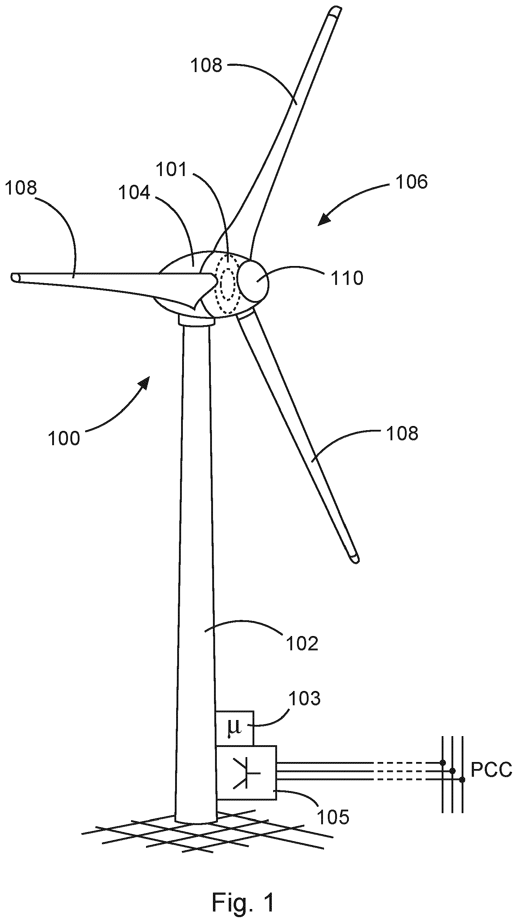

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

Die Windenergieanlage 100 weist dabei einen elektrischen Generator 101 auf, der in der Gondel 104 angedeutet ist. Mittels des Generators 101 kann elektrische Leistung erzeugt werden. Zum Einspeisen elektrischer Leistung ist eine Einspeiseeinheit 105 vorgesehen, die besonders als Wechselrichter ausgebildet sein kann. Damit kann ein dreiphasiger Einspeisestrom und/oder eine dreiphasige Einspeisespannung nach Amplitude, Frequenz und Phase erzeugt werden, zum Einspeisen an einem Netzanschlusspunkt PCC. Das kann direkt oder auch gemeinsam mit weiteren Windenergieanlagen in einem Windpark erfolgen. Zum Steuern der Windenergieanlage 100 und auch der Einspeiseeinheit 105 ist eine Anlagensteuerung 103 vorgesehen. Die Anlagensteuerung 103 kann auch Vorgabewerte von extern, insbesondere von einem zentralen Parkrechner erhalten.

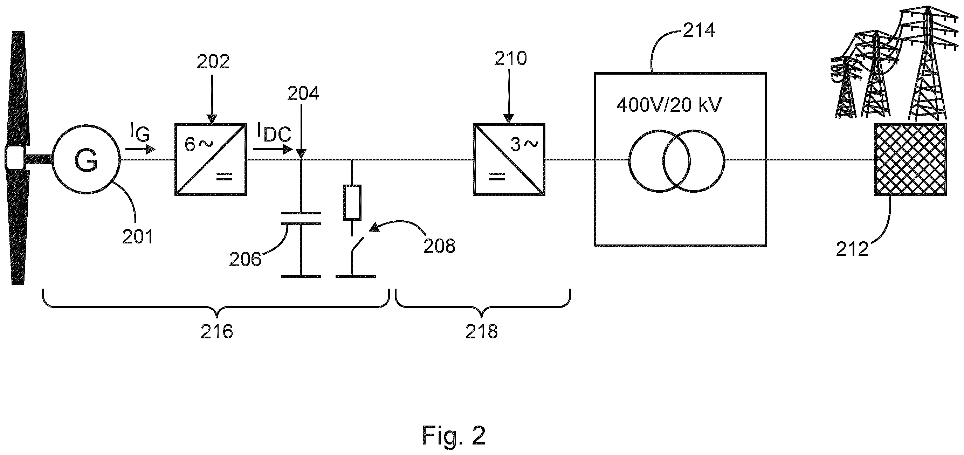

Fig. 2 zeigt den Leistungspfad der elektrischen Leistung. Er beginnt beim Generator 201, der als Synchrongenerator ausgebildet sein kann, und der als Generatorstrom I_{G} einen elektrischen Wechselstrom erzeugt, besonders einen Statorstrom. Der Generatorstrom I_{G} wird über den aktiven Gleichrichter 202 gleichgerichtet und als Gleichrichtstrom I_{DC} auf einen Gleichspannungszwischenkreis 204 gegeben. Dadurch wird auch der Generatorstrom I_{G}, insbesondere der Statorstrom gesteuert. Dadurch kann auch ein Generatorstrom I_{G} gesteuert werden, der Leistung in den Generator eingibt, wenn elektrische Leistung aus dem elektrischen Versorgungsnetz aufgenommen wird.

Der Gleichspannungszwischenkreis 204 weist einen Zwischenkreiskondensator 206 auf, der auch als Glättungskondensator bezeichnet werden kann. Außerdem ist an den Gleichspannungszwischenkreis 204 ein Chopperkreis 208 angeschlossen, der elektrische Leistung und damit elektrische Energie aus dem Gleichspannungszwischenkreis abführen kann.

Von dem Gleichspannungszwischenkreis 204 wird mit einem netzseitigen Wechselrichter 210 ein Einspeisestrom als Wechselstrom erzeugt, um dadurch elektrische Leistung, nämlich Wirkleistung, in das elektrische Versorgungsnetz 212 einzuspeisen. Zwischen dem Wechselrichter 210 und dem elektrischen Versorgungsnetz 212 ist zudem ein Transformator 214 angeordnet.

Die Windenergieanlage, insbesondere der netzseitige Wechselrichter 210, arbeiten dabei spannungsprägend, insbesondere netzbildend.

Der Gleichrichter 202 führt hier zusammen mit dem Chopperkreis 208 eine Regelung des Gleichspannungszwischenkreises, also der Zwischenkreisspannung durch. Diese Regelung kann als Zwischenkreisregelung 216 bezeichnet werden. Der Gleichrichter 202 führt eine Regelung der Zwischenkreisspannung durch, die eine untere Strombegrenzung für den Gleichrichtstrom beinhaltet. Wird die untere Strombegrenzung erreicht, kann die Zwischenkreisspannung durch den Gleichrichter 202 nicht mehr gehalten werden und der Chopperkreis 208 kann dann die Regelung der Zwischenkreisspannung übernehmen. Deshalb führen der Gleichrichter 202 und der Chopperkreis 208 gemeinsam die Regelung der Zwischenkreisspannung durch. Das unterscheidet sich somit von einer Variante, bei der der Gleichrichter ohne untere Strombegrenzung, oder mit sehr viel höherer untere Strombegrenzung, die Regelung der Zwischenkreisspannung alleine durchführt.

Außerdem ist in dem Wechselrichter 210 eine dynamische Stromgrenze 218 implementiert, die zu große Sprünge des Einspeisestromes verhindert, um dadurch große Drehmomentsprünge am Generator zu vermeiden.

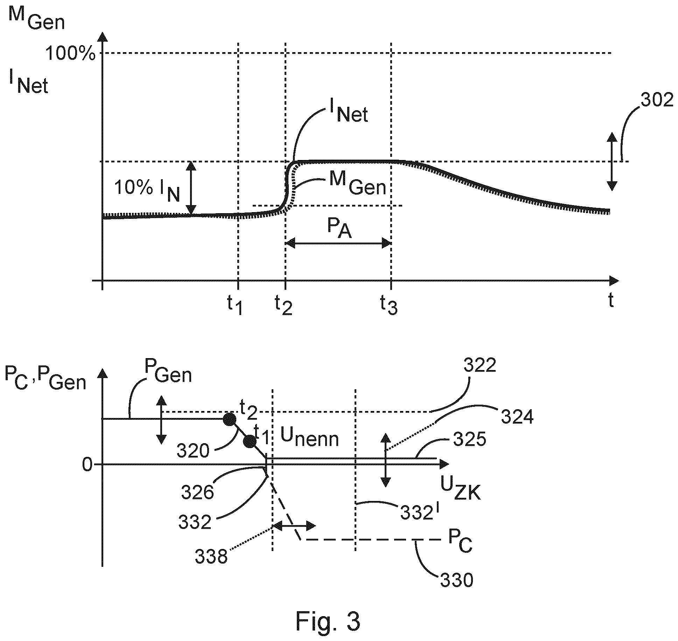

Fig. 3 zeigt zwei Teildiagramme, die zumindest einen Teil der Wirkungsweise des vorgeschlagenen Verfahrens erläutern.

Im oberen Diagramm ist ein zeitlicher Verlauf eines in das elektrische Versorgungsnetz eingespeisten Einspeisestroms I_{Net} und eines zugehörigen Drehmomentes M_{Gen} für eine Beispielsituation gezeigt.

In der Beispielsituation wird angenommen, dass ein großer netzseitiger Stromstoß oberhalb eines aktuellen Einspeisestromes auftritt. Dafür ist eine untere Strombegrenzung 302 vorgesehen, die von dem Einspeisestrom erreicht wird und z.B. um 10 % des Nennstroms I_{N} oberhalb es aktuellen Einspeisestroms liegen kann. In diesem Beispiel beträgt somit der maximale Strom-, Leistungs- und Drehmomentenstoß in positiver Richtung 10 %. Somit wird durch die dynamische Strombegrenzung nur ein Drehmomentenstoß entsprechend des Limits minus des aktuellen Stroms zugelassen. Diese Strombegrenzung 302 ist somit verschiebbar, was der Doppelpfeil andeutet. Der Stoß beginnt zum Zeitpunkt t₂ und endet zum Zeitpunkt t₃ und dazwischen ergibt sich eine Ausregelleistung P_{A}, die für den Zeitraum dazwischen, der durch einen Doppelpfeil angedeutet ist, wirkt, auch wenn ihre Höhe begrenzt ist. Es kann somit geregelt werden, ohne aber die Windenergieanlage zu überlasten.

Die Limitierung kann auch über eine Statik der Zwischenkreisregelung erfolgen. Dann würde der netzseitige spannungsprägende Wechselrichter bei einbrechender Zwischenkreis-Spannung den Einspeisestrom limitieren. Er würde somit seine Strombegrenzung über die Zwischenkreisspannung erkennen.

Nach dem Drehmomentensprung werden über eine PT1-Charakteristik die Limits an den aktuellen Arbeitspunkt herangefahren. Die Verzögerungscharakteristik ergibt sich aus der zulässigen mechanischen Belastung.

Das untere Teildiagramm der Figur 3 zeigt, wie eine Realisierung des Verfahrens mittels entsprechend eingestellter Statiken durchgeführt werden kann. Statiken geben einen Zusammenhang vor, besonders einen linearen Zusammenhang zwischen einer Eingangsgröße und einer Ausgangsgröße. Hier ist eine Gleichrichterstatik 320 zu Grunde gelegt worden, die einen Zusammenhang zwischen der Zwischenkreisspannung U_{ZK} und der Generatorleistung P_{Gen} angibt. Sie ist als durchgezogene Linien dargestellt. Hier ist der Einfachheit halber die Gleichrichterstatik dann auf Höhe etwas über der Koordinatenachse gezeigt, die einen Normalwert oder mittleren Wert markiert. Bei niedrigen Zwischenkreisspannungen wird demnach die Generatorleistung P_{Gen} entsprechend der Gleichrichtstatik 320 erhöht, bis zu einem maximalen Wert.

In dem gezeigten Beispiel liegt zum Zeitpunkt t₁ noch kein Stromstoß oder Stromsprung vor. Die Zeitpunkte aus dem oberen Teildiagramm sind zur besseren Orientierung im unteren Teildiagramm als Arbeitspunkte der Gleichspannungsregelung eingezeichnet. Zum Zeitpunkt t₁, also im Normalbetrieb, liegt der korrespondierende Arbeitspunkt auf einer Flanke der Statik des Gleichrichters, also der Gleichrichterstatik 320. Der Gleichrichter führt somit eine Regelung der Zwischenkreisspannung durch.

Zum Zeitpunkt t₂ tritt der Stromstoß auf, der durch einen Phasensprung der Netzspannung ausgelöst sein kann und dadurch verringert sich die Zwischenkreisspannung, was den Arbeitspunkt verändert. Die Generatorleistung P_{Gen} steigt dadurch an, bis zum maximalen Wert gemäß der Gleichrichterstatik 320. Das ist an die Strombegrenzung des netzseitigen Wechselrichters angepasst.

Die ebenfalls eingezeichnete Chopperstatik 330, die als gestichelte Linien dargestellt ist, kommt bei diesem Beispiel nicht zur Anwendung, weil die Zwischenkreisspannung unter ihren Nennwert sinkt und damit den Chopperkreis nicht auslöst. Die Gleichrichterstatik 320 und auch die Chopperstatik 330 sind dynamisch veränderbar und sie stehen hier repräsentativ für eine Gleichrichterregelung bzw. eine Choppereregelung. Dazu wird für die Gleichrichterstatik 320 besonders vorgeschlagen, dass ihre Endwerte verändert werden können. Das ist durch den ersten und zweiten Änderungsdoppelpfeil 322 und 324 angedeutet.

Dabei bildet der untere Endwert der Gleichrichterstatik 320 eine untere Leistungsbegrenzung 325, die durch eine untere Strombegrenzung realisiert werden kann, oder umgekehrt. Diese untere Leistungsbegrenzung 325 ist dynamisch veränderbar, was der Änderungsdoppelpfeil 324 andeutet. Die Flanke der Gleichrichterstatik 320 reicht bis zum Zwischenkreisreferenzwert 326 der Zwischenkreisspannung U_{ZK}. Abhängig davon, auf welchen Wert die Leistungsbegrenzung 325 eingestellt wird, verändert sich auch der Zwischenkreisreferenzwert 326. Die Chopperstatik 330 kann entsprechend angepasst werden, indem die Auslösespannung 332 auf den Zwischenkreisreferenzwert 326 gelegt wird. Das ist in der Figur 3 dadurch erkennbar, dass die Chopperstatik 330 die Abszisse, also die Nulllinie bei dem Zwischenkreisreferenzwert 326 erreicht.

Alternativ kann eine feste Auslösespannung 332' vorgesehen sein, die fest auf einem Wert oberhalb des Zwischenkreisreferenzwertes 326 liegt und auch oberhalb einer Nennspannung der Zwischenkreisspannung UZK.

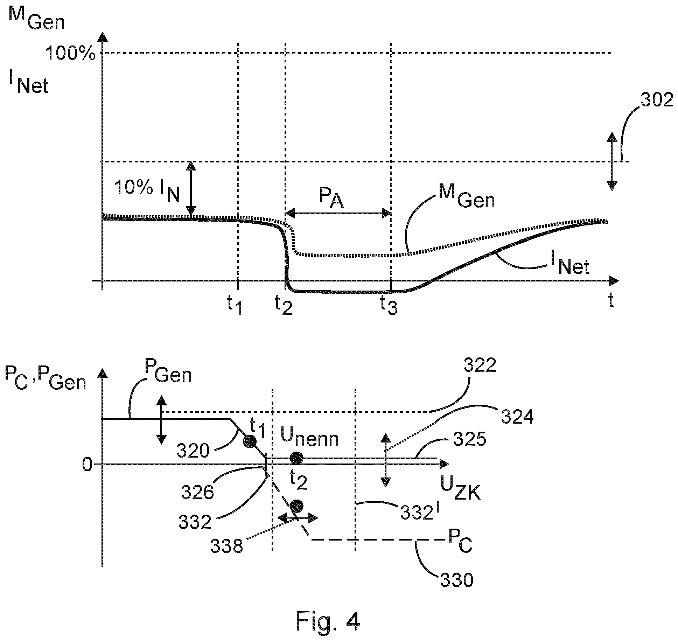

Die Erläuterungen des unteren -Diagramms sind für die Figur 4 identisch, bis auf die Erläuterungen der Betriebspunkte. Die Chopperstatik 330, die vorstehend zu Fig. 3 erläutert wurde, entfaltet für die Betriebssituation der Figur 3 noch keine Wirkung. Nachfolgend wird daher im Zusammenhang mit Figur 4 eine Betriebssituation gezeigt, bei der die Chopperstatik 330 ihre Wirkung entfaltet, insbesondere im Zusammenwirken mit der Gleichrichterstatik 320.

Fig. 4 zeigt somit eine Betriebssituation, bei der die eingespeiste Leistung, also Wirkleistung, sprunghaft abnimmt. Das wird hier als negativer Lastsprung bezeichnet. Zum Zeitpunkt t₁ liegt noch ein Normalbetrieb vor, und dabei ist, wie in Figur 3, der Zeitpunkt t₁ auf einer Flanke der Gleichrichterstatik 320, die hier aus drei durchgezogenen Linien dargestellt ist. Die Gleichrichterstatik 320 und auch die Chopperstatik 330 sind hier identisch zur Fig. 3, weil die vorliegende Figur 4 nur eine andere Betriebssituation, aber keine geänderte Regelung zeigt.

Zum Zeitpunkt t₂ tritt der sprunghafte Einbruch der eingespeisten Leistung und damit des Einspeisestromes I_{Net} auf, also der negative Lastsprung. Dadurch erhöht sich die Zwischenkreisspannung U_{ZK}. Der Arbeitspunkt verändert sich dadurch entlang der Gleichrichterstatik 320. Die Gleichrichterstatik 320 fällt aber mit steigender Zwischenkreisspannung nur bis zur Leistungsbegrenzung 325 ab, um damit einen Grenzwert für die zugeordnete Generatorleistung zu erreichen. Auch hier ist die Leistungsbegrenzung 325 über der Koordinatenachse gezeigt, die den Leistungswert null kennzeichnet.

Der Gleichrichter führt somit den Gleichrichtstrom und damit letztlich die Generatorleistung dem Abfallen der Zwischenkreisspannung nur soweit nach, bis nämlich der rechte waagerechte Zweig der Gleichrichterstatik erreicht ist, bis also die Leistungsbegrenzung 325 erreicht ist. Damit fällt das Generatormoment etwas ab, aber nicht vollständig.

Der Arbeitspunkt, bzw. ein Arbeitspunkt liegt aber auf der Chopperstatik 330 und fällt mit ihr bei zunehmender Zwischenkreisspannung weiter ab. Die Auslösespannung 332 ist hier auf den Zwischenkreisreferenzwert 326 gelegt.

Entsprechend führt der Chopperkreis Leistung aus dem Zwischenkreis ab. Das führt dazu, dass das Generatormoment beschränkt werden konnte, ein weiterer Abfall der eingespeisten Leistung aber nicht beschränkt werden musste. Das ist durch die Darstellung des Einspeisestromes I_{Net} verdeutlicht. Das Generatormoment M_{Gen} und der Einspeisestrom I_{Net} sind in dem oberen Teildiagramm jeweils auf ihre Nennwerte normiert dargestellt, so dass sie ohne die beschriebene Begrenzung des Drehmomentes etwa übereinanderliegen müssten.

Bei negativen Lastsprüngen wird somit durch dynamische Limits in der Statik der Zwischenkreisregelung der Drehmomentenstoß limitiert.

Die Chopprstatik 330 kann ebenfalls dynamisch verschoben werden, um die weitere Leistung zu übernehmen. Besonders wird vorgeschlagen, dass dazu die Auslösespannung 332 dem Zwischenkreisreferenzwert 326 nachgeführt wird, wodurch die einer Veränderung der Leistungsbegrenzung 325 nachgeführt wird, also einer Veränderung der unteren Strombegrenzung. Die Chopperstatik 330 wird natürlich entsprechend angepasst, indem ihre Flanke verschoben wird, was durch den Doppelpfeil 338 angedeutet ist. Eine Verschiebung der unteren Leistungsbegrenzung gemäß dem Änderungspfeil 324 führt somit zu einer Änderung der Chopperstatik gemäß dem Doppelpfeil 338.

In der Figur 4 korrigiert fängt der Beginn der Chopperstatik 330, die auch als Chopper-Kennlinie bezeichnet werden kann, somit natürlich erst im Nullpunkt an, der auf der Abszisse der Zwischenkreisspannung liegt. Für die Platzierung der Chopper-Kennlinie werden zwei Möglichkeiten vorgeschlagen. Entweder ist die Chopper-Kennlinie rechts von der gesamten Statik der Zwischenkreisregelung, also gemäß den Figuren 3 und 4 rechts von der Flanke der Gleichrichterstatik 320, also rechts von dem Zwischenkreisreferenzwert 326. Ist der Gleichrichtstrom limitiert, ist also die Generatorleistung limitiert, muss die Zwischenkreisspannung erst eine gewisse Höhe erreichen, bis der Chopperkreis aktiv wird. Das ist als alternative Möglichkeit mit der alternativen Auslösespannung 332' eingezeichnet.

Die zweite Möglichkeit ist eine Verschiebung nach links. Der Beginn ist dann die Zwischenkreisspannung, bei der die Limitierung des Stroms beginnt, als bei dem Zwischenkreisreferenzwert 326, was in den Figuren 3 und 4 als Hauptvariante eingezeichnet ist. Zusammen mit dem dynamischen Limit der Leistungsbegrenzung 325 ergibt sich so eine kontinuierliche Regelung.

Maximaler Strom-, Leistungs- und Drehmomentenstoß für den Generator in negativer Richtung ist 10 %. Der Einspeisestrom kann dabei aber viel stärker abfallen, er gefährdet aber keine Überlastung des Generators.

Der Chopperkreis, der einfach als Chopper bezeichnet werden kann, übernimmt die zusätzliche Leistung (hier ca. 15 %). Es bilden sich zwei Arbeitspunkte bei t₂.

Nach dem Drehmomentensprung werden über eine PT1-Charakteristik die Limits an den aktuellen Arbeitspunkt herangefahren. Die Verzögerungscharakteristik ergibt sich aus der zulässigen mechanischen Belastung. Der Gleichrichter übernimmt darüber hinaus verzögert die Leistung, welche im Chopper umgesetzt wird.

Mit dem vorgeschlagenen Verfahren wird somit die folgende Situation vermieden bzw. verbessert:
Ohne die vorgeschlagenen Begrenzungen läuft ein netzseitiger Stromstoß, der bei einer Spannungsänderung durch die spannungsprägende Einspeisung entstehen kann, nahezu ungehindert in das Generatordrehmoment. Das Generatormoment kann also ebenso stark ansteigen. Ein Chopperkreis würde aber auch bei negativen Leistungsgradienten nicht aktiv, denn die aus den negativen Leistungsgradienten resultierende Spannungsänderung der Zwischenkreisspannung würde durch den aktiven Gleichrichter ausgeregelt werden.

Der Chopperkreis übernimmt erst, wenn der generatorseitige Gleichrichter seine Stromgrenze erreicht. Damit wären Strom-, Leistungs- und Drehmomentsprünge nicht beschränkt und es können solche Sprünge bis zu 100 % des Nennwertes betragen.

Es wurde somit eine Lösung geschaffen, die eine Bereitstellung netzbildender Eigenschaften mit einer Windenergieanlage ermöglicht, ohne oder ohne große Überdimensionierung des mechanischen Systems und ohne Integration eines elektrischen Speichers, also der über einen üblichen Zwischenkreiskondensator hinausgeht.

Der Erfindung liegt die Überlegung zu Grunde, dass das mechanische System einer Windenergieanlage, die auch als WEA abgekürzt werden kann, Drehmomentensprünge von z.B. maximal 10 % aushält. Netzbildende Eigenschaften an den Anlagenklemmen erfordern aber eine Zwischenkreisregelung auf der Generatorseite, welche zu hohen Transienten im Drehmoment führen können. Das wirkt wie eine direkte Kopplung vom Generator mit dem Netz.

Die Idee ist es, Laststöße durch eine Spannungsprägung in positiver und in negativer Richtung zu begrenzen. In positiver Richtung, wenn also die eingespeiste Wirkleistung bzw. der zugehörige Wirkstrom Iᵢₛₜ des Einspeisestroms I_{Net} erhöht wird, kann dies besonderes durch eine Limitierung des Ausgangsstroms auf z.B. Iᵢₛₜ +10 % I_{N} erfolgen. Alternativ oder ergänzend kann auch das Limit in der Statik der Zwischenkeisregelung dynamisch angepasst werden.

In negativer Richtung, wenn also die eingespeiste Leistung bzw. der zugehörige Wirkstrom I_{Net} bzw. Iᵢₛₜ verringert wird, erfolgt die Limitierung vorzugsweise durch eine dynamische Anpassung einer Chopperstatik und eine Limitierung der Statik der Zwischenkreisregelung des generatorseitigen Umrichters, der auch als generatorseitiger Wechselrichter oder aktiver Gleichrichter bezeichnet werden kann.

Die Nachführung nach einem Laststoß erfolgt mittels einer Zeitverzögerung, z.B. gemäß einem PT1-Verhalten.

Bei einer Erhöhung der eingespeisten Leistung kann eine Stromlimitierung bei dem netzseitigen spannungsprägenden Wechselrichter direkt erfolgen, oder es wird auf eine stark einbrechende Zwischenkreisspannung mit einer Stromlimitierung reagiert. Eine solche einbrechende Zwischenkreisspannung kann resultieren, wenn der aktive Gleichrichter, also der generatorseitige Gleichrichter, den Drehmomentensprung begrenzt.

Klassischerweise ist eine Windenergieanlage so aufgebaut, dass der Generator vom Netz entkoppelt ist. Eine Regelung der Zwischenkreisspannung erfolgt durch den netzseitigen Wechselrichter.

Eine Windenergieanlage mit netzbildendem Umrichter bzw. Wechselrichter kann so aufgebaut sein, dass der Generator vom Netz entkoppelt ist, indem eine Zwischenkreisregelung, also eine Regelung der Zwischenkreisspannung, durch einen Batteriespeicher mit Gleichstromsteller erfolgt. Dazu ist der Batteriespeicher über den Gleichstromsteller, der damit auch als speicherseitiger DC/DC-Steller bezeichnet werden kann, gekoppelt. Der Batteriespeicher kann die Regelung der Zwischenkreisspannung durchführen.

Um diesen Aufwand mit dem Batteriespeicher zu vermeiden, wird eine Windenergieanlage mit netzbildendem Umrichter bzw. netzbildendem Wechselrichter vorgeschlagen, bei der der Generator grundsätzlich mit dem Netz, also mit dem elektrischen Versorgungsnetz gekoppelt ist, nämlich durch eine Zwischenkreisregelung durch einen generatorseitigen Wechselrichter, der auch als generatorseitiger Gleichrichter, oder aktiver Gleichrichter bezeichnet werden kann.

Dazu wird nun vorgeschlagen, dass für die Windenergieanlage mit netzbildendem Umrichter bzw. Wechselrichter der Generator vom Netz entkoppelt wird. Dazu wird eine Zwischenkreisregelung durch einen Chopperkreis, der synonym auch einfach als Chopper bezeichnet werden kann, vorgeschlagen, mit generatorseitigem aktiven Gleichrichter. Eine Drehmomentbegrenzung wird dabei durch eine dynamische netzseitige Stromgrenze realisiert.

## Patentansprüche

1. Verfahren zum Einspeisen elektrischer Leistung in ein eine Netzspannung aufweisendes elektrisches Versorgungsnetz (212) mittels einer Windenergieanlage (100), wobei die Windenergieanlage (100) umfasst
- einen Generator (201) zum Erzeugen eines Generatorstroms (I_{G}),
- einen mit dem Generator (201) verbundenen aktiven Gleichrichter (202) zum Gleichrichten des Generatorstroms (I_{G}) in einen Gleichrichtstrom (I_{DC}),
- einen mit dem aktiven Gleichrichter (202) verbundenen und eine Zwischenkreisspannung (U_{ZK}) aufweisenden Gleichspannungszwischenkreis (204) zum Aufnehmen des Gleichrichtstroms (I_{DC}),
- einen mit dem Gleichspannungszwischenkreis (204) verbundenen Chopperkreis (208), um überschüssige Energie aus dem Gleichspannungszwischenkreis abzuführen,
- einen mit dem Gleichspannungszwischenkreis (204) verbundenen Wechselrichter (210) zum Erzeugen eines Einspeisestroms (I_{Net}) zum Einspeisen in das elektrische Versorgungsnetz (212), wobei
- das Einspeisen spannungsprägend erfolgt, sodass der Wechselrichter (210) einer Abweichung der Netzspannung von einem Spannungssollwert durch eine Anpassung des eingespeisten Stroms entgegenwirkt,
- der aktive Gleichrichter (202) eine untere Strombegrenzung aufweist, die bei einer Änderung der Netzspannung in Amplitude und/oder Phasenlage einen Abfall des Gleichrichtstroms (I_{DC}) zum Schutz des Generators (201) begrenzt,
- wobei die untere Strombegrenzung des aktiven Gleichrichters (202) als Gleichrichtstrombegrenzung bezeichnet wird und in Abhängigkeit von einem Betriebspunkt der Windenergieanlage (100), insbesondere in Abhängigkeit von einem Betriebspunkt des aktiven Gleichrichters (202), eingestellt und verändert wird und
- der Chopperkreis (208) so gesteuert wird, dass er überschüssige Energie, die durch die Strombegrenzung des aktiven Gleichrichters (202) in dem Gleichspannungszwischenkreis (204) auftritt, oder einen Teil davon, aus dem Gleichspannungszwischenkreis abführt.

2. Verfahren nach Anspruch 1, **dadurch gekennzeichnet, dass**
- der Chopperkreis (208) Energie aus dem Gleichspannungszwischenkreis (204) abführt, sobald die Zwischenkreisspannung (U_{ZK}) eine Auslösespannung erreicht hat,
- der aktive Gleichrichter (202) durch das Steuern des Gleichrichtstroms (I_{DC}) die Zwischenkreisspannung regelt, insbesondere unter Verwendung einer Gleichrichterstatik, um die Zwischenkreisspannung (U_{ZK}) auf einen Wert oder Bereich unterhalb der Auslösespannung zu regeln, wobei
- dann, wenn der Gleichrichtstrom (I_{DC}) die Gleichrichtstrombegrenzung erreicht und dadurch beschränkt wird, die Zwischenkreisspannung weiter ansteigt und die Auslösespannung erreicht, sodass der Chopperkreis (208) anspricht und Energie aus dem Gleichspannungszwischenkreis (204) abführt.

3. Verfahren nach Anspruch 1 oder 2, **dadurch gekennzeichnet, dass**
- der Chopperkreis (208) eine Chopperstatik (330) aufweist, die einen Zusammenhang, insbesondere einen linearen Zusammenhang zwischen einem eine bzw. die Auslösespannung überschreitenden Spannungswert der Zwischenkreisspannung und einer aus dem Gleichspannungszwischenkreis (204) abzuführenden Chopperleistung angibt.

4. Verfahren nach einem der vorstehenden Ansprüche, **dadurch gekennzeichnet, dass**
- zum Regel der Zwischenkreisspannung eine Regelungsvorschrift, insbesondre eine Regelungsstatik, vorgesehen ist, und die Regelungsvorschrift sich zusammensetzt aus
- einer Gleichrichterregelung, insbesondere einer Gleichrichterstatik, und einer Chopperregelung, insbesondere einer bzw. der Chopperstatik, wobei
- die Gleichrichterregelung einen Zusammenhang vorgibt zwischen der Zwischenkreisspannung und dem durch den aktiven Gleichrichter einzustellenden Gleichrichtstrom, derart, dass
- der einzustellende Gleichrichtstrom mit ansteigender Zwischenkreisspannung abfällt, insbesondere linear abfällt, bis der Gleichrichtstrom die untere Strombegrenzung erreicht hat, und
- der einzustellende Gleichrichtstrom bei weiter steigender Zwischenkreisspannung auf dieser unteren Strombegrenzung gehalten wird, und
- die Chopperregelung einen Zusammenhang vorgibt zwischen der Zwischenkreisspannung und einer bzw. der durch den Chopperkreis aus dem Zwischenkreis abzuführenden Chopperleistung, derart, dass
- die Chopperleistung mit zunehmender Zwischenkreisspannung zunimmt, sobald die Zwischenkreisspannung eine bzw. die Auslösespannung überschreitet, wobei
- die untere Strombegrenzung und/oder die Auslösespannung veränderbar sind und insbesondere in Abhängigkeit eines Arbeitspunktes der Windenergieanlage verändert werden, wobei insbesondere
- die untere Strombegrenzung und die Auslösespannung in Abhängigkeit von einander verändert werden, insbesondere so, dass
- die Auslösespannung in Abhängigkeit von der unteren Strombegrenzung eingestellt wird und bei Änderungen der unteren Strombegrenzung ebenfalls geändert wird, und/oder
- die Auslösespannung auf einen Zwischenkreisreferenzwert gesetzt wird, den die Zwischenkreisspannung erreicht, wenn der Gleichrichtstrom auf die Strombegrenzung abgefallen ist, und/oder die Auslösespannung in Abhängigkeit des Zwischenkreisreferenzwertes eingestellt wird, insbesondere auf einen Wert, der um weniger als 5% von dem Zwischenkreisreferenzwert abweicht.

5. Verfahren nach einem der vorstehenden Ansprüche, **dadurch gekennzeichnet, dass**
- die Strombegrenzung des aktiven Gleichrichters (202) als dynamische Funktion in Abhängigkeit von dem aktuellen Gleichrichtstrom (I_{DC}) ausgebildet ist, insbesondere so ausgebildet ist, dass sie
- im stationären Fall um eine Unterschreitungsdifferenz unter dem aktuellen Gleichrichtstrom liegt und
- im Falle eines Abfalls des Gleichrichtstroms, dem Gleichrichtstrom abzüglich der Unterschreitungsdifferenz mit einer dynamischen Funktion, nachgeführt wird, wobei
- die dynamische Funktion ein Tiefpassverhalten aufweist, insbesondere ein PT1-Verhalten.

6. Verfahren nach einem der vorstehenden Ansprüche, **dadurch gekennzeichnet, dass**
- der Wechselrichter (210) eine obere Wechselrichterstrombegrenzung aufweist, um bei einem Spannungsabfall der Netzspannung einen Anstieg des Einspeisestroms (I_{Net}) zum Schutz des Generators (201) nach oben zu begrenzen, wobei insbesondere
- die obere Wechselrichterstrombegrenzung in Abhängigkeit von einem Betriebspunkt der Windenergieanlage (100), insbesondere des Wechselrichters (210) und/oderder Zwischenkreisspannung eingestellt und verändert wird.

7. Verfahren nach einem der vorstehenden Ansprüche, **dadurch gekennzeichnet, dass**
- eine bzw. die obere Wechselrichterstrombegrenzung als dynamische Funktion in Abhängigkeit von dem aktuellen Einspeisestrom (I_{Net}) ausgebildet ist, insbesondere so ausgebildet ist, dass sie
- im stationären Fall um eine Überschreitungsdifferenz über dem aktuellen Einspeisestrom (I_{Net}) liegt und
- im Falle eines Anstiegs des Einspeisestroms (I_{Net}), dem Einspeisestrom (I_{Net}) zuzüglich der Überschreitungsdifferenz mit einer dynamischen Funktion, nachgeführt wird, wobei
- die dynamische Funktion ein Tiefpassverhalten aufweist, insbesondere ein PT1-Verhalten, wobei sich vorzugsweise
- die Überschreitungsdifferenz von der Zwischenkreisspannung abhängt, insbesondere von einem Überschreitungswert abhängt, um den die Zwischenkreisspannung eine bzw. die Auslösespannung überschreitet.

8. Verfahren nach einem der vorstehenden Ansprüche, **dadurch gekennzeichnet, dass**
- eine Erhöhung einer eingespeisten Wirkleistung auf einen Wert im Bereich von 5% bis 20% oberhalb der eingespeisten Wirkleistung, bezogen auf die eingespeiste Wirkleistung oder bezogen auf eine Nennleistung der Windenergieanlage (100) begrenzt wird, wobei
- eine Verringerung der eingespeisten Wirkleistung bis zu einem Wert von -100% bezogen auf die eingespeiste Wirkleistung oder bezogen auf die Nennleistung der Windenergieanlage (100) zugelassen wird.

9. Windenergieanlage (100) zum Einspeisen elektrischer Leistung in ein eine Netzspannung aufweisendes elektrisches Versorgungsnetz (212), wobei die Windenergieanlage umfasst
- einen Generator (201) zum Erzeugen eines Generatorstroms (I_{G}),
- einen mit dem Generator verbundenen aktiven Gleichrichter (202) zum Gleichrichten des Generatorstroms in einen Gleichrichtstrom,
- einen mit dem aktiven Gleichrichter verbundenen und eine Zwischenkreisspannung aufweisenden Gleichspannungszwischenkreis (204) zum Aufnehmen des Gleichrichtstroms,
- einen mit dem Gleichspannungszwischenkreis verbundenen Chopperkreis (208), um überschüssige Energie aus dem Gleichspannungszwischenkreis abzuführen,
- einen mit dem Gleichspannungszwischenkreis verbundenen Wechselrichter (210) zum Erzeugen eines Einspeisestroms (I_{Net}) zum Einspeisen in das elektrische Versorgungsnetz (212), und
- eine Anlagensteuerung (103), die dazu vorbereitet ist, das Einspeisen so zu steuern, dass
- das Einspeisen spannungsprägend erfolgt, sodass der Wechselrichter einer Abweichung der Netzspannung von einem Spannungssollwert durch eine Anpassung des eingespeisten Stroms entgegenwirkt,
- der aktive Gleichrichter (202) eine untere Strombegrenzung aufweist, um bei einer Änderung der Netzspannung in Amplitude und/oder Phasenlage einen Abfall des Gleichrichtstroms zum Schutz des Generators zu begrenzen,
- wobei die untere Strombegrenzung des aktiven Gleichrichters (202) als Gleichrichtstrombegrenzung bezeichnet wird und die Anlagensteuerung dazu eingerichtet ist, die untere Strombegrenzung in Abhängigkeit von einem Betriebspunkt der Windenergieanlage (100), insbesondere in Abhängigkeit von einem Betriebspunkt des aktiven Gleichrichters (202), einzustellen und zu verändern, und
- wobei die Anlagensteuerung ferner dazu eingerichtet ist, den Chopperkreis (208) so zu steuern, dass er überschüssige Energie, die durch die Strombegrenzung des aktiven Gleichrichters (202) in dem Gleichspannungszwischenkreis auftritt, oder einen Teil davon, aus dem Gleichspannungszwischenkreis abführt.

10. Windenergieanlage (100) nach Anspruch 9, **dadurch gekennzeichnet, dass** die Anlagensteuerung (103) dazu vorbereitet ist, ein Verfahren gemäß einem der Ansprüche 2 bis 8 auszuführen.

## Claims

1. A method for feeding electrical power into an electrical supply grid (212) having a grid voltage by means of a wind power installation (100), wherein the wind power installation (100) comprises
- a generator (201) for generating a generator current (I_{G}),
- an active rectifier (202) connected to the generator (201) for rectifying the generator current (I_{G}) into a rectified current (I_{DC}),
- a direct voltage intermediate circuit (204) connected to the active rectifier (202) and having an intermediate circuit voltage (U_{ZK}) for receiving the rectified current (I_{DC}),
- a chopper circuit (208) connected to the direct voltage intermediate circuit (204) for diverting excess energy out of the direct voltage intermediate circuit,
- an inverter (210) connected to the direct voltage intermediate circuit (204) for generating an infeed current (I_{Net}) for feeding into the electrical supply grid (212), wherein
- the feed takes place in a voltage-impressing manner, so that the inverter (210) counteracts a deviation of the grid voltage from a voltage setpoint value through an adjustment of the fed current,
- the active rectifier (202) has a lower current limit , which in the presence of a change of the grid voltage in its amplitude and/or phase, limits a fall of the rectified current (I_{DC}) to protect the generator (201),
- wherein the lower current limit of the active rectifier (202) is referred to as rectified current limitation, and is set and changed depending on an operating point of the wind power installation (100), in particular depending on an operating point of the active rectifier (202), and
- the chopper circuit (208) is controlled in such a way that it diverts excess energy that arises in the direct voltage intermediate circuit (204) as a result of the current limit of the active rectifier (202), or a portion thereof, out of the direct voltage intermediate circuit.

2. The method as claimed in claim 1, wherein
- the chopper circuit (208) diverts energy from the direct voltage intermediate circuit (204) as soon as the intermediate circuit voltage (U_{ZK}) has reached a trigger voltage,
- the active rectifier (202), through the control of the rectified current (I_{DC}), regulates the intermediate circuit voltage, in particular making use of a rectifier droop function in order to regulate the intermediate circuit voltage (U_{ZK}) to a value or range below the trigger voltage, wherein
- when the rectified current (I_{DC}) has reached the rectified current limit and is thereby limited, the intermediate circuit voltage continues to rise and reaches the trigger voltage, so that the chopper circuit (208) responds and diverts energy out of the direct voltage intermediate circuit (204).

3. The method as claimed in claim 1 or 2, wherein
- the chopper circuit (208) has a chopper droop function (330) that specifies a relationship, in particular a linear relationship, between a voltage value of the intermediate circuit voltage that exceeds a or the trigger voltage and a chopper power to be diverted from the direct voltage intermediate circuit (204).

4. The method as claimed in one of the preceding claims, wherein
- a regulation specification, in particular a regulation droop function, is provided for regulating the intermediate circuit voltage, and the regulation specification is composed of
- a rectifier regulation, in particular a rectifier droop function, and a chopper regulation, in particular a (or the) chopper droop function, wherein
- the rectifier regulation specifies a relationship between the intermediate circuit voltage and the rectified current to be set through the active rectifier in such a way that
- the rectified current to be set falls with rising intermediate circuit voltage, in particular falls linearly, until the rectified current has reached the lower current limit, and
- the rectified current to be set as the intermediate circuit voltage continues to rise is held at this lower current limit, and
- the chopper regulation specifies a relationship between the intermediate circuit voltage and a (or the) chopper power to be diverted from the intermediate circuit by the chopper circuit in such a way that
- the chopper power increases with rising intermediate circuit voltage as soon the intermediate circuit voltage exceeds a (or the) trigger voltage, wherein
- the lower current limit and/or the trigger voltage are changeable, and in particular are changed depending on a working point of the wind power installation, wherein in particular
- the lower current limit and the trigger voltage are changed depending on one another, in particular in such a way that
- the trigger voltage is set depending on the lower current limit, and is also changed when there are changes to the lower current limit, and/or
- the trigger voltage is set to an intermediate circuit reference value that the intermediate circuit voltage reaches when the rectified current has fallen to the current limit, and/or the trigger voltage is set depending on the intermediate circuit reference value, in particular to a value that differs by less than 5% from the intermediate circuit reference value.

5. The method as claimed in one of the preceding claims, wherein
- the current limit of the active rectifier (202) is designed as a dynamic function depending on the rectified current (I_{DC}) at that moment, in particular designed such that it
- in the stationary case, lies below the rectified current at that moment by an undershoot difference and
- in the event of a fall in the rectified current, it tracks the rectified current less the undershoot difference with a dynamic function, wherein
- the dynamic function has a low-pass behavior, in particular a PT1 behavior.

6. The method as claimed in one of the preceding claims, wherein
- the inverter (210) has an upper inverter current limit in order, in the event of a voltage drop in the grid voltage, to place an upward limit on a rise of the infeed current (I_{Net}) to protect the generator (201), wherein in particular
- the upper inverter current limit is set and changed depending on an operating point of the wind power installation (100), in particular of the inverter (210) and/or of the intermediate circuit voltage.

7. The method as claimed in one of the preceding claims, wherein
- an (or the) upper inverter current limit is designed as a dynamic function depending on the infeed current (I_{Net}) at that moment, in particular designed such that
- in the stationary case, it lies above the infeed current (I_{Net}) at that moment by an overshoot difference and
- in the event of a rise in the infeed current (I_{Net}), it tracks the infeed current (I_{Net}) plus the overshoot difference with a dynamic function, wherein
- the dynamic function has a low-pass behavior, in particular a PT1 behavior, wherein preferably
- the overshoot difference depends on the intermediate circuit voltage, in particular on the overshoot value by which the intermediate circuit voltage exceeds a or the trigger voltage.

8. The method as claimed in one of the preceding claims, wherein
- an increase in a real power fed in is limited to a value in the range from 5% to 20% above the real power fed in in relation to the real power fed in or in relation to a rated power of the wind power installation (100), wherein
- a reduction of the real power fed in of up to a value of -100% in relation to the real power fed in or in relation to the rated power of the wind power installation (100) is permitted.

9. A wind power installation (100) for feeding electrical power into an electrical supply grid (212) having a grid voltage, wherein the wind power installation comprises
- a generator (201) for generating a generator current (I_{G}),
- an active rectifier (202) connected to the generator for rectifying the generator current into a rectified current,
- a direct voltage intermediate circuit (204) connected to the active rectifier and having an intermediate circuit voltage for receiving the rectified current,
- a chopper circuit (208) connected to the direct voltage intermediate circuit for diverting excess energy out of the direct voltage intermediate circuit,
- an inverter (210) connected to the direct voltage intermediate circuit for generating an infeed current (I_{Net}) for feeding into the electrical supply grid (212), and
- an installation controller (103) that is prepared to control the feed in such a way that
- the feed takes place in a voltage-impressing manner, so that the inverter counteracts a deviation of the grid voltage from a voltage setpoint value through an adjustment of the fed current,
- the active rectifier (202) has a lower current limit in order, in the presence of a change of the grid voltage in its amplitude and/or phase, to limit a fall of the rectified current to protect the generator,
- wherein the lower current limit of the active rectifier (202) is referred to as rectified current limitation, and the installation controller is arranged to set and change the lower current limit depending on an operating point of the wind power installation (100), in particular depending on an operating point of the active rectifier (202), and
- wherein the installation controller is also arranged to control the chopper circuit (208) in such a way that it diverts excess energy that arises in the direct voltage intermediate circuit as a result of the current limit of the active rectifier (202), or a portion thereof, out of the direct voltage intermediate circuit.

10. A wind power installation (100) as claimed in claim 9, wherein the installation controller (103) is prepared to carry out a method as claimed in one of claims 2 to 8.

## Revendications

1. Procédé d'injection de puissance électrique dans un réseau d'alimentation (212) électrique présentant une tension de réseau au moyen d'une éolienne (100), dans lequel l'éolienne (100) comporte
- un générateur (201) pour la génération d'un courant de générateur (I_{G}),
- un redresseur (202) actif relié au générateur (201) pour le redressement du courant de générateur (I_{G}) en un courant de redressement (I_{DC}),
- un circuit intermédiaire à tension continue (204) relié au redresseur (202) actif et présentant une tension de circuit intermédiaire (U_{ZK}) pour la réception du courant de redresseur (I_{DC}),
- un circuit de chopper (208) relié au circuit intermédiaire à tension continue (204) afin d'évacuer de l'énergie excédentaire hors du circuit intermédiaire à tension continue,
- un onduleur (210) relié au circuit intermédiaire à tension continue (204) pour la génération d'un courant d'injection (I_{NET}) pour l'injection dans le réseau d'alimentation (212) électrique, dans lequel
- l'injection est effectuée en étant **caractérisée par** tension de sorte que l'onduleur (210) agisse contre un écart de la tension de réseau d'une valeur de consigne de tension par une adaptation du courant injecté,
- le redresseur (202) actif présente une limitation de courant inférieure qui limite lors d'une modification de la tension de réseau en amplitude et/ou couche de phase une chute du courant de redresseur (I_{DC}) pour la protection du générateur (201),
- dans lequel la limitation de courant inférieure du redresseur actif (202) est désignée par la limitation de courant de redresseur et est réglée et modifiée en fonction d'un point de fonctionnement de l'éolienne (100), en particulier en fonction d'un point de fonctionnement du redresseur (202) actif,
et
- le circuit de chopper (208) est commandé de sorte qu'il évacue de l'énergie excédentaire qui frappe par la limitation de courant du redresseur (202) actif dans le circuit intermédiaire à tension continue (204), ou une partie de celui-ci, hors du circuit intermédiaire à tension continue.

2. Procédé selon la revendication 1, **caractérisé en ce que**
- le circuit de chopper (208) évacue de l'énergie hors du circuit intermédiaire à tension continue (204) dès que la tension de circuit intermédiaire (U_{ZK}) a atteint une tension de déclenchement,
- le redresseur (202) actif régule par la commande du courant de redresseur (I_{DC}) la tension de circuit intermédiaire, en particulier en utilisant une statique de redresseur afin de réguler la tension de circuit intermédiaire (U_{ZK}) à une valeur ou zone sous la tension de déclenchement, dans lequel
- ensuite lorsque le courant de redresseur (I_{DC}) atteint la limitation de courant de redresseur et est limité du fait que la tension de circuit intermédiaire augmente encore et atteint la tension de déclenchement de sorte que le circuit de chopper (208) réponde et évacue de l'énergie hors du circuit intermédiaire à tension continue (204).

3. Procédé selon la revendication 1 ou 2, **caractérisé en ce que**
- le circuit de chopper (208) présente une statique de chopper (330) qui indique un rapport, en particulier un rapport linéaire entre une valeur de tension dépassant une ou la tension de déclenchement de la tension de circuit intermédiaire et une puissance de chopper à évacuer hors du circuit intermédiaire à tension continue (204).

4. Procédé selon l'une quelconque des revendications précédentes, **caractérisé en ce que**
- pour réguler la tension de circuit intermédiaire une prescription de régulation, en particulier une statique de régulation, est prévue, et la prescription de régulation se compose de
- une régulation de redresseur, en particulier une statique de redresseur, et une régulation de chopper, en particulier une ou la statique de chopper, dans lequel la régulation de redresseur prescrit un rapport entre la tension de circuit intermédiaire et le courant de redresseur à régler par le redresseur actif de telle manière que
- le courant de redresseur à régler avec une tension de circuit intermédiaire croissante diminue, en particulier diminue linéairement jusqu'à ce que le courant de redresseur a atteint la limitation de courant inférieure, et
- le courant de redresseur à régler est maintenu en cas de tension de circuit intermédiaire croissant encore à cette limitation de courant inférieure, et
- la régulation de chopper prescrit un rapport entre la tension de circuit intermédiaire et une ou la puissance de chopper à évacuer par le circuit de chopper hors du circuit intermédiaire de telle manière que
- la puissance de chopper avec une tension de circuit intermédiaire croissante augmente dès que la tension de circuit intermédiaire dépasse une ou la tension de déclenchement, dans lequel
- la limitation de courant inférieure et/ou la tension de déclenchement sont modifiables et en particulier sont modifiées en fonction d'un point de travail de l'éolienne, dans lequel en particulier
- la limitation de courant inférieure et la tension de déclenchement sont modifiées en fonction l'une de l'autre en particulier de sorte que
- la tension de déclenchement soit réglée en fonction de la limitation de courant inférieure et soit aussi modifiée lors de modifications de la limitation de courant inférieure, et/ou
- la tension de déclenchement est placée à une valeur de référence de circuit intermédiaire que la tension de circuit intermédiaire atteint, lorsque le courant de redresseur est tombé à la limitation de courant, et/ou la tension de déclenchement est réglée en fonction de la valeur de référence de circuit intermédiaire, en particulier à une valeur qui diverge de moins de 5 % de la valeur de référence de circuit intermédiaire.

5. Procédé selon l'une quelconque des revendications précédentes, **caractérisé en ce que**
- la limitation de courant du redresseur (202) actif est réalisée comme fonction dynamique en fonction du courant de redresseur (I_{DC})actuel, en particulier est réalisée de sorte qu'elle
- se trouve dans le cas stationnaire d'une différence de non-atteinte sous le courant de redresseur actuel et
- dans le cas d'une chute du courant de redresseur, soit ajoutée au courant de redresseur moins la différence de non-atteinte avec une fonction dynamique, dans lequel
- la fonction dynamique présente un comportement passe-bas, en particulier un comportement PT1.

6. Procédé selon l'une quelconque des revendications précédentes, **caractérisé en ce que**
- l'onduleur (210) présente une limitation de courant d'onduleur supérieure afin de limiter lors d'une chute de tension de la tension de réseau une montée du courant d'injection (I_{NET}) pour la protection du générateur (201) vers le haut, dans lequel en particulier
- la limitation de courant d'onduleur supérieure est réglée et modifiée en fonction d'un point de fonctionnement de l'éolienne (100), en particulier de l'onduleur (210) et/ou de la tension de circuit intermédiaire.

7. Procédé selon l'une quelconque des revendications précédentes, **caractérisé en ce que**
- une ou la limitation de courant d'onduleur supérieure est réalisée comme fonction dynamique en fonction du courant d'injection (I_{NET}) actuel, en particulier est réalisé de sorte qu'elle
- se trouve dans le cas stationnaire d'une différence de dépassement au-dessus du courant d'injection (I_{NET}) actuel et
- dans le cas d'une montée du courant d'injection (I_{NET}) soit ajoutée au courant d'injection (I_{NET}) plus la différence de dépassement avec une fonction dynamique, dans lequel
- la fonction dynamique présente un comportement passe-bas, en particulier un comportement PT1, dans lequel de préférence
- la différence de dépassement dépend de la tension de circuit intermédiaire, en particulier dépend d'une valeur de dépassement, de laquelle la tension de circuit intermédiaire dépasse une ou la tension de déclenchement.

8. Procédé selon l'une quelconque des revendications précédentes, **caractérisé en ce que**
- une augmentation d'une puissance active injectée est limitée à une valeur dans la plage de 5 % à 20 % au-dessus de la puissance active injectée, par rapport à la puissance active injectée ou par rapport à une puissance nominale de l'éolienne (100), dans lequel
- une diminution de la puissance active injectée est autorisée jusqu'à une valeur de -100 % par rapport à la puissance active injectée ou par rapport à la puissance nominale de l'éolienne (100).

9. Eolienne (100) pour l'injection de puissance électrique dans un réseau d'alimentation (212) électrique présentant une tension de réseau, dans laquelle l'éolienne comporte
- un générateur (201) pour la génération d'un courant de générateur (I_{G}),
- un redresseur (202) actif relié au générateur pour le redressement du courant de générateur en un courant de redressement,
- un circuit intermédiaire à tension continue (204) relié au redresseur actif et présentant une tension de circuit intermédiaire pour la réception du courant de redressement,
- un circuit de chopper (208) relié au circuit intermédiaire à tension continue afin d'évacuer de l'énergie excédentaire hors du circuit intermédiaire à tension continue,
- un onduleur (210) relié au circuit intermédiaire à tension continue pour la génération d'un courant d'injection (I_{NET}) pour l'injection dans le réseau d'alimentation électrique (212), et
- une commande d'installation (103) qui est préparée afin de commander l'injection de sorte que
- l'injection soit effectuée en étant **caractérisée par** tension de sorte que l'onduleur agisse contre un écart de la tension de réseau d'une valeur de consigne de tension par une adaptation du courant injecté,
- le redresseur (202) actif présente une limitation de courant inférieure afin de limiter lors d'une modification de la tension de réseau en amplitude et/ou couche de phase une chute du courant de redressement pour la protection du générateur,
- dans lequel la limitation de courant inférieure du redresseur (202) actif est désignée par limitation de courant de redressement et la commande d'installation est conçue afin de régler et modifier la limitation de courant inférieure en fonction d'un point de fonctionnement de l'éolienne (100), en particulier en fonction d'un point de fonctionnement du redresseur (202) actif, et
- dans lequel la commande d'installation est de plus conçue afin de commander le circuit de chopper (208) de sorte qu'il évacue de l'énergie excédentaire qui frappe par la limitation de courant du redresseur (202) actif dans le circuit intermédiaire à tension continue, ou une partie de celui-ci, hors du circuit intermédiaire à tension continue.

10. Eolienne (100) selon la revendication 9, **caractérisée en ce que** la commande d'installation (103) est préparée afin de réaliser un procédé selon l'une quelconque des revendications 2 à 8.
